# EUROPEAN PATENT SPECIFICATION

(11) **EP 3 014 692 B1**
(45) Date of publication and mention of the grant of the patent: **15.08.2018**
(21) Application number: 14818496.3
(22) Date of filing: 24.06.2014
(51) Int. Cl.: H01M 10/48, H01M 10/04, G01R 31/36, G01R 31/02, H01M 10/42

(54) **DETECTION MECHANISM**
DETEKTIONSMECHANISMUS
MÉCANISME DE DÉTECTION

(30) Priority: 28.06.2013 US 201313931695
(43) Date of publication of application: 04.05.2016
(73) Proprietor: Intel Corporation, Santa Clara, CA 95054 (US)
(72) Inventor: MATSUMURA, Naoki, San Jose, CA 95118 (US)
(74) Representative: HGF Limited
(86) International application number: PCT/US2014/043856
(87) International publication number: WO 2014/209992

(56) References cited:
- JP-A- S5 885 281
- JP-A- H08 180 853
- JP-A- 2010 073 558
- JP-A- 2010 157 449
- JP-A- 2011 034 952
- JP-A- 2011 124 104
- JP-A- 2011 124 104
- US-A1- 2010 124 250
- US-B1- 6 366 056
- Matthew Z. Mayers ET AL: "Suppression of Dendrite Formation via Pulse Charging in Rechargeable Lithium Metal Batteries", Journal of Physical Chemistry C, vol. 116, no. 50, 20 December 2012 (2012-12-20), pages 26214-26221, XP055316787, US ISSN: 1932-7447, DOI: 10.1021/jp309321w

## Description

### Background Art

Various electronic devices such as portable computing devices include batteries. A battery is a power storage device that includes one or more electrochemical cells that convert stored chemical energy into electrical energy. Batteries have two electrodes, a cathode and an anode. By definition, in electrochemical cells, positively charged ions flow from the anode to the cathode, while electrons flow through an external circuit from the anode to the cathode. Although the definition of the anode and cathode are reversed during the recharge cycle, as used herein, the terms anode and cathode will refer to the electrodes in the discharge cycle.

In some cases, batteries may malfunction due to dendrite formation. A dendrite is a deposit, for example, of metal formed at the anode during charging of the battery. When a dendrite that has formed on the anode comes in contact with the cathode, the battery may short circuit, leading to very high current flows through the dendrite.

JP 2011 124104 A, describes a lithium ion battery capable of detecting an internal short circuit due to contamination of metallic foreign matter. In this prior art document, a conductive layer is embedded in a separator layer between an anode and a cathode. During battery charging, the voltage and current is measured between one of the electrodes and the conductive layer so as to detect a dendrite growing from the anode that may lead to a short-circuit. The battery charging is then stopped when a short-circuit is detected. JP S58 85281 A, describes a zinc battery wherein a conductive film is embedded in a separator layer between an anode and a cathode. During battery charging the voltage is measured between the anode and the conductive film so as to detect a dendrite growing from the anode that may lead to a short-circuit. The article from Matthew Z. Mayers ET AL published in Journal of Physical Chemistry C, vol. 116, no. 50, 20 December 2012, pages 26214-26221, XP055316787, US, ISSN: 1932-7447, DOI: 10.1021/jp309321 relates to the "Suppression of Dendrite Formation via Pulse Charging in Rechargeable Lithium Metal Batteries".

### Brief Description of the Drawings

FIG. 1 is a diagram illustrating a cross sectional side view of a battery including a detection mechanism.
FIG. 2 is a diagram illustrating a peripheral view of a plurality of detection grids to be disposed in the dielectric of the battery.
FIG. 3 is a diagram illustrating a cross sectional side view of a battery including a plurality of detection grids.
FIG. 4 is a block diagram illustrating a method of forming a detection grid.

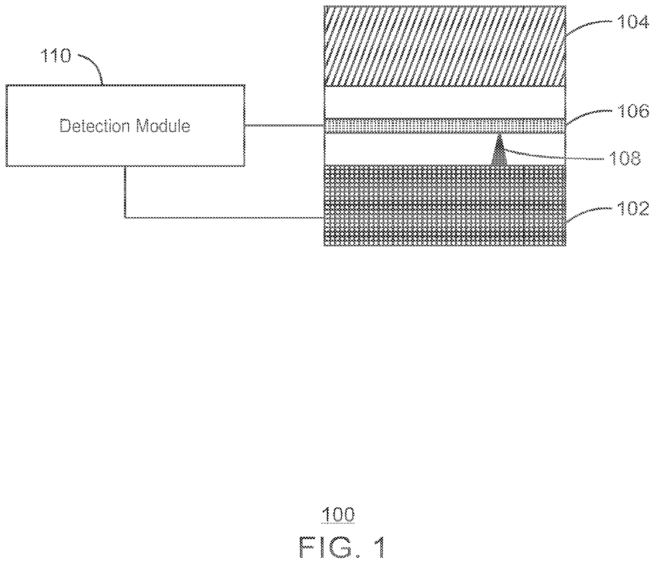

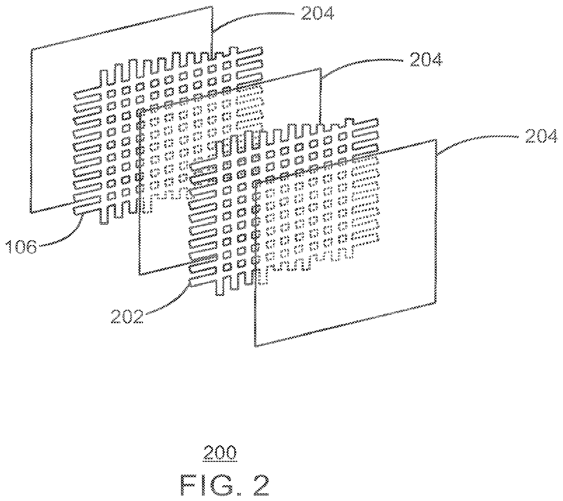

The same numbers are used throughout the disclosure and the figures to reference like components and features. Numbers in the 100 series refer to features originally found in FIG. 1; numbers in the 200 series refer to features originally found in FIG. 2; and so on.

### Description of the Embodiments

The invention is defined by the claims. The present disclosure relates generally to a detection mechanism to detect dendrite formation in a battery. The detection mechanism may include a detection grid. The grid may be disposed between a cathode and an anode of the battery. The detection grid may be composed of conductive material and communicatively coupled to the anode such that when a dendrite is formed on the anode and contacts the detection grid an impedance may be detected.

Fig. 1 is a diagram illustrating a cross sectional side view of a battery including a detection mechanism. The battery 100 may include an anode 102 and a cathode 104. The battery 100 includes a detection grid 106 configured to detect a formation 108, such as a dendrite. The formation 108 may be formed during a charge, or recharge, cycle of the battery 100.

The battery 100 is an electrochemical cell battery. In embodiments, the battery 100 is a rechargeable battery including various electrically conductive materials for the cathode 104 and the anode 102. In a lithium ion-battery, for example, the anode 104 may be composed, for example, of lithium metal, a composite of lithium and carbon, or other materials. The cathode 104 may be composed of, for example, lithium iron phosphate, lithium cobalt oxide, or other similar materials. The battery 100 may include other rechargeable battery types such as lead-acid batteries, nickel cadmium batteries, nickel metal hydride batteries, lithium polymer batteries, and the like. In these rechargeable battery types, the anode 102 and cathode 104 will, of course, have different compositions.

During recharge, dendrites may form at the anode 102 as illustrated by the dendrite 108 of Fig. 1. Dendrites are deposits of conductive material, such as lithium metal, that may form on the surface of the anode 102 during recharge of the battery 100. As noted herein, the definitions of the anode and cathode during the discharge cycle will be used consistently. Dendrite formation may become problematic if the dendrite 108 communicatively couples the anode 102 to the cathode 104.

The detection mechanism of the battery 100 includes a detection grid 106 and a detection module 110. As illustrated in Fig. 1, the dendrite 108 may form at the anode 102. As the dendrite 108 forms, the dendrite 108 may communicatively couple the detection grid 106 to the anode 102. The detection module 110 may be configured to monitor an impedance value between the anode 102 and the detection grid 104. When the dendrite 108 is communicatively coupled to the detection grid 106, the detection module 110 may detect a change, for example, a decrease, in the impedance value due to the coupling between the dendrite 108 and the detection grid 106. The detection module 110 may be configured to reduce or mitigate the formation of the dendrite by reducing recharge of the battery 100.

In embodiments, the detection grid 106 has an opening to enable ion flow between the anode 102 and the cathode 104. The opening, described in more detail below, may be defined by a grid pattern of the detection grid 106. While the opening may be large enough to enable ion flow, the opening may be small enough to prevent a dendrite from passing through the opening undetected by the detection module 110.

Although Fig. 1 illustrates various components of the battery 100, additional components may be used. Further, the battery 100 may be communicatively coupled to an electronic device, and the battery 100 may include components configured to provide electrical charge to the electronic device. Additionally, the battery 100 may be configured to receive electrical charge from a charging device that may plug into a wall outlet, for example.

Fig. 2 is a diagram illustrating a peripheral view of a plurality of detection grids to be disposed in the dielectric of the battery. Like numbered items are as described in Fig. 1. In some embodiments, the detection grid 106 is a first detection grid and the battery may include a second detection grid 202. The detection grids 106, 202 may be disposed within dielectric material 204. The dielectric material 204 may be electrolyte mixture such as such as ethylene carbonate or diethyl carbonate containing complexes of lithium ions in the case of a lithium ion battery. In some embodiments, the dielectric material may include an absorbent material that is saturated with the electrolyte mixture. In some embodiments, the dielectric material may be solid-state electrolyte which conducts lithium ions.

As illustrated in Fig. 2, the detection grids 106, 202 may include an opening, or a number of openings configured to enable ions to flow between a cathode and an anode of a battery, such as the battery 100 of Fig. 1. The openings may be small enough to prevent dendrites from passing through the grid without detection. In some embodiments, the detection grids 106, 202 may be laterally offset with respect to each other in order to reduce the ability of a dendrite from passing through the detection grids 106, 202 undetected.

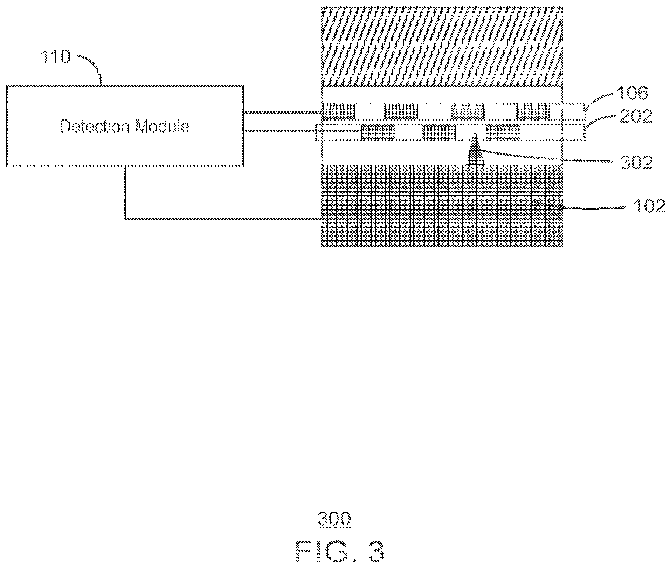

Fig. 3 is a diagram illustrating a cross sectional side view of a battery including a plurality of detection grids. Like numbered items are as described in Figs. 1 and 2. The detection grids 106, 202, are indicated by the dashed boxes in Fig. 3. As illustrated in Fig. 3, the first detection grid 106 is laterally offset with respect to the second detection grid 202. By providing two detection grids 106, 202, and by disposing each detection grid as laterally offset with respect to each other, a dendrite 302 may be substantially prevented from passing through the second detection grid 202 without being detected by the first detection grid 106. The first and the second detection grids 106, 202 may be communicatively coupled to the detection module 110 and to the anode 102. As discussed above, the detection module 110 may be configured to measure the impedance between the anode and the detection grids 106, 202. If a dendrite, such as the dendrite 302 shown in Fig. 3, communicatively couples to either detection grid 106, 202, the impedance value may be relatively less than if the dendrite was not coupled to either detection grid 106, 202. Generally, the detection module 110 may be configured to take action if a dendrite is detected, for example, by reducing or stopping any charging processes of the battery 100 in order to significantly reduce further dendrite formation or growth, or by applying high voltage pulses to break down the dendrite, among others. In the context of the claimed invention, the detection module 110 is configured to apply high voltage pulses when a dendrite is detected.

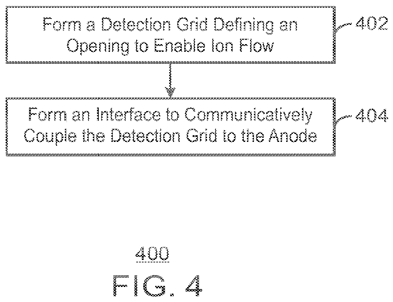

FIG. 4 is a block diagram illustrating a method of forming a detection mechanism. The method 400 may include forming, at block 402, a detection grid defining an opening to enable ion flow. The detection grid may be formed between an anode and a cathode of a battery. The detection grid may detect when a deposit, such as a dendrite, formed at the anode. The method 400 may include forming, at block 404, an interface to communicatively couple the detection grid to the anode of the battery. The interface may be a mechanism to enable the communicative coupling via a two-wire interface for example.

In embodiments, the interface includes detection circuitry configured to reduce charging activity of the battery when the deposit contacts the detection grid. For example, the detection grid is composed of conductive material. The detection circuitry may be configured to monitor the impedance value between the anode and the detection grid. Once the deposit formed on the surface of the anode approaches or contacts the detection grid, the impedance value may drop, and the detection circuitry may reduce charging activity of the battery.

In embodiments, the detection grid is a first detection grid. The method 400 may include forming a second detection grid. The first and the second detection grid may be configured to be laterally offset from each other to enable electron flow between the cathode and the anode, and to prevent a dendrite to pass through either detection grid undetected.

Reference in the specification to "an embodiment," "one embodiment," "some embodiments," "various embodiments," or "other embodiments" means that a particular feature, structure, or characteristic described in connection with the embodiments is included in at least some embodiments, but not necessarily all embodiments, of the present techniques. The various appearances of "an embodiment," "one embodiment," or "some embodiments" are not necessarily all referring to the same embodiments.

If the specification or claim refers to "a" or "an" element, that does not mean there is only one of the element. If the specification or claims refer to "an additional" element, that does not preclude there being more than one of the additional element.

It is to be noted that, although some embodiments have been described in reference to particular implementations, other implementations are possible according to some embodiments. Additionally, the arrangement and/or order of circuit elements or other features illustrated in the drawings and/or described herein need not be arranged in the particular way illustrated and described. Many other arrangements are possible according to some embodiments.

In each system shown in a figure, the elements in some cases may each have a same reference number or a different reference number to suggest that the elements represented could be different and/or similar. However, an element may be flexible enough to have different implementations and work with some or all of the systems shown or described herein. The various elements shown in the figures may be the same or different. Which one is referred to as a first element and which is called a second element is arbitrary.

It is to be understood that specifics in the aforementioned examples may be used anywhere in one or more embodiments. For instance, all optional features of the computing device described above may also be implemented with respect to either of the methods or the computer-readable medium described herein.

Furthermore, although flow diagrams and/or state diagrams may have been used herein to describe embodiments, the techniques are not limited to those diagrams or to corresponding descriptions herein. For example, flow need not move through each illustrated box or state or in exactly the same order as illustrated and described herein.

The present techniques are not restricted to the particular details listed herein. Indeed, those skilled in the art having the benefit of this disclosure will appreciate that many other variations from the foregoing description and drawings may be made within the scope of the present techniques. Accordingly, it is the following claims that define the scope of the present techniques.

## Claims

1. A detection mechanism, comprising a detection grid (106) to be disposed in a dielectric material between a cathode (104) and an anode (102) of a battery (100) and detection circuitry (110) to monitor an impedance value between the anode and the detection grid (106), wherein the detection grid is composed of a conductive material and the detection circuitry (110) is configured to use the impedance value to detect when a dendrite (108) formed at the anode (102) contacts the detection grid (106), and wherein the detection circuitry (110) is configured to apply a high voltage pulse to break down the dendrite (108).

2. The detection mechanism of claim 1, wherein the detection grid comprises an opening to enable ion flow between the cathode and the anode.

3. The detection mechanism of claim 1, comprising a second detection grid to be disposed between the cathode and the anode of the battery.

4. The detection mechanism of claim 3, wherein the second detection grid is laterally offset with respect to the first detection grid.

5. A method for forming a detection mechanism, comprising:
forming (402) a detection grid to be disposed between a cathode and an anode of a battery; and
forming (404) an interface to communicatively couple the detection grid to the anode, wherein the interface includes detection circuitry to monitor an impedance value between the anode and the detection grid, wherein the detection grid is composed of a conductive material and the detection circuitry uses the impedance value to detect when a dendrite formed at the anode contacts the detection grid, and wherein the detection circuitry is to apply a high voltage pulse to break down the dendrite.

6. The method of claim 5, wherein the detection grid defines an opening to enable ion flow between the cathode and the anode.

7. The method of any of claims 5 or 6, wherein the detection grid is a first detection grid, the method comprising forming a second detection grid to be disposed between the cathode and the anode of the battery.

8. The method of claim 7, wherein the second detection grid is to be disposed laterally offset with respect to the first detection grid.

## Patentansprüche

1. Detektionsmechanismus, umfassend ein Detektionsgitter (106), das in einem dielektrischen Material zwischen einer Kathode (104) und einer Anode (102) einer Batterie (100) anzuordnen ist, und Detektionsschaltung (110) zum Überwachen eines Impedanzwertes zwischen der Anode und dem Detektionsgitter (106), wobei das Detektionsgitter aus einem leitfähigen Material besteht und die Detektionsschaltung (110) dazu ausgelegt ist, den Impedanzwert zu verwenden, um zu detektieren, wann ein an der Anode (102) gebildeter Dendrit (108) in Kontakt mit dem Detektionsgitter (106) kommt, und wobei die Detektionsschaltung (110) dazu ausgelegt ist, Impulse mit hoher Spannung anzulegen, um den Dendriten (108) aufzubrechen.

2. Detektionsmechanismus nach Anspruch 1, wobei das Detektionsgitter eine Öffnung umfasst, um einen Ionenstrom zwischen der Kathode und der Anode zu ermöglichen.

3. Detektionsmechanismus nach Anspruch 1, umfassend ein zweites Detektionsgitter, das zwischen der Kathode und der Anode der Batterie anzuordnen ist.

4. Detektionsmechanismus nach Anspruch 3, wobei das zweite Detektionsgitter bezüglich des ersten Detektionsgitters lateral versetzt ist.

5. Verfahren zum Ausbilden eines Detektionsmechanismus, das Folgendes umfasst:
Ausbilden (402) eines zwischen einer Kathode und einer Anode einer Batterie anzuordnenden Detektionsgitters; und
Ausbilden (404) einer Schnittstelle, um das Detektionsgitter kommunikativ mit der Anode zu koppeln,
wobei die Schnittstelle eine Detektionsschaltung umfasst, um einen Impedanzwert zwischen der Anode und dem Detektionsgitter zu überwachen, wobei das Detektionsgitter aus einem leitfähigen Material besteht und die Detektionsschaltung den Impedanzwert verwendet, um zu detektieren, wann ein an der Anode gebildeter Dendrit in Kontakt mit dem Detektionsgitter kommt, und
wobei die Detektionsschaltung dazu dient, Impulse mit hoher Spannung anzulegen, um den Dendriten aufzubrechen.

6. Verfahren nach Anspruch 5, wobei das Detektionsgitter eine Öffnung definiert, um einen Ionenstrom zwischen der Kathode und der Anode zu ermöglichen.

7. Verfahren nach einem der Ansprüche 5 oder 6, wobei das Detektionsgitter ein erstes Detektionsgitter ist, wobei das Verfahren Ausbilden eines zwischen der Kathode und der Anode der Batterie anzuordnenden zweiten Detektionsgitters umfasst.

8. Verfahren nach Anspruch 7, wobei das zweite Detektionsgitter bezüglich des ersten Detektionsgitters lateral versetzt anzuordnen ist.

## Revendications

1. Mécanisme de détection, comprenant une grille de détection (106) devant être disposée dans un matériau diélectrique entre une cathode (104) et une anode (102) d'une batterie (100) et un circuit de détection (110) pour surveiller une valeur d'impédance entre l'anode et la grille de détection (106), la grille de détection étant composée d'un matériau conducteur et le circuit de détection (110) étant configuré pour utiliser la valeur d'impédance pour détecter lorsqu'une dendrite (108) formée au niveau de l'anode (102) entre en contact avec la grille de détection (106), et le circuit de détection (110) étant configuré pour appliquer une impulsion haute tension pour décomposer la dendrite (108).

2. Mécanisme de détection selon la revendication 1, la grille de détection comprenant une ouverture pour permettre un écoulement d'ions entre la cathode et l'anode.

3. Mécanisme de détection selon la revendication 1, comprenant une seconde grille de détection destinée à être disposée entre la cathode et l'anode de la batterie.

4. Mécanisme de détection selon la revendication 3, la seconde grille de détection étant latéralement décalée par rapport à la première grille de détection.

5. Procédé de formation d'un mécanisme de détection, comprenant :
la formation (402) d'une grille de détection devant être disposée entre une cathode et une anode d'une batterie ; et
la formation (404) d'une interface pour coupler en communication la grille de détection à l'anode, l'interface comprenant un circuit de détection pour surveiller une valeur d'impédance entre l'anode et la grille de détection, la grille de détection étant composée d'un matériau conducteur et le circuit de détection utilisant la valeur d'impédance pour détecter lorsqu'une dendrite formée au niveau de l'anode entre en contact avec la grille de détection, et le circuit de détection étant destiné à appliquer une impulsion haute tension pour décomposer la dendrite.

6. Procédé selon la revendication 5, la grille de détection définissant une ouverture pour permettre un écoulement d'ions entre la cathode et l'anode.

7. Procédé selon l'une quelconque des revendications 5 ou 6, la grille de détection étant une première grille de détection, le procédé comprenant la formation d'une seconde grille de détection devant être disposée entre la cathode et l'anode de la batterie.

8. Procédé selon la revendication 7, la seconde grille de détection devant être disposée latéralement décalée par rapport à la première grille de détection.
